# EUROPÄISCHE PATENTSCHRIFT

(11) **EP 0 357 910 B1**
(45) Veröffentlichungstag und Bekanntmachung des Hinweises auf die Patenterteilung: **16.09.1998**
(21) Anmeldenummer: 89112900.9
(22) Anmeldetag: 14.07.1989
(51) Int. Cl.: H01L 39/14

(54) **Verfahren zur Herstellung eines supraleitenden langgestreckten Gutes aus einem beschichteten gewellten Metallrohr**
Method of producing a superconductive elongate material made of a coated corrugated metal pipe
Procédé de fabrication d'un matériau allongé supraconducteur d'un tuyau ondulé revêtu

(30) Priorität: 29.08.1988 DE 3829227
(43) Veröffentlichungstag der Anmeldung: 14.03.1990
(73) Patentinhaber: ALCATEL ALSTHOM COMPAGNIE GENERALE D'ELECTRICITE, 75008 Paris (FR)
(72) Erfinder: Van Hove, Cornelius, D-3012 Langenhagen 6 (DE)
(74) Vertreter: Mende, Eberhard, Dipl.-Ing.

(56) Entgegenhaltungen:
- EP-A- 274 407
- EP-A- 304 116
- EP-A- 321 813
- WO-A-88/08618
- WO-A-89/02656
- AT-B- 278 126
- DE-A- 1 812 025
- DE-A- 2 136 019
- DE-A- 3 915 403
- DE-B- 1 170 483
- INFRARED PHYSICS, Band 29, Nr. 2-4, Mai 1989, Seiten 607-630, Pergamon Press Plc, GB, & 4th INTERNATIONAL CONFERENCE ON INFRARED PHYSICS, Zurich, 22nd-26th August 1988; J. ARNESSON et al.: "Proposal for a particle accelerator driven by a far-infrared free-electron laser"
- JAPANESE JOURNAL OF APPLIED PHYSICS, Band 29, Nr. 9, September 1990, Seiten L1655-L1658
- APPLIED PHYSICS LETTERS, Band 55, Nr. 5, 31. Juli 1989, Seiten 492-494
- JAPANESE JOURNAL OF APPLIED PHYSICS, Band 26, Nr. 10, Oktober 1987, Seiten 1653-1656
- JAPANESE JOURNAL OF APPLIED PHYSICS, Band 26, Nr. 7, Juli 1987, Seiten L1172-L1173
- APPLIED PYHSICS LETTERS, Band 51, Nr. 3, 1987, Seiten 203-204
- FOURTH INTERNATIONAL CONFERENCE ON INFRARED PHYSICS, ETH Zürich, Switzerland, 22.-26. August 1988, Proceedings, verteilt am 22. August 1988

## Beschreibung

Die vorliegende Erfindung betrifft ein Verfahren zur Herstellung eines supraleitenden langgestreckten Gutes aus einem metallischen Träger, der mit einem Mischoxid beschichtet ist, dessen Sprungtemperatur bei 100 K und darüber liegt. Ein solches Verfahren ist aus Japanese Journal of Applied Physics, July 87, vol. 26, No. 7, pages L1172-L1173 bekannt.

Bekannt ist bereits ein Verfahren zur Herstellung eines Supraleiters in flexibler Form, bei dem zunächst auf einen durchlaufenden metallischen Träger eine supraleitfähige Schicht durch Metallspritzen in einem Plasma aufgebracht wird. Der beschichtete Träger wird dann von einem längseinlaufenden Metallband umhüllt, anschließend wird das so gebildete Rohr mit Spalt längsnahtverschweißt und schließlich zumindest auf den äußeren Durchmesser der supraleitfähigen Schicht heruntergezogen (DE-OS 21 08 635). Als supraleitfähige Schicht dient hierbei die intermetallische Verbindung Nb₃Sn, die jedoch eine verhältnismäßig niedrige Sprungtemperatur aufweist, so daß wegen der hohen Anlageund Kühlkosten auf Basis dieser Verbindungen hergestellte Leiter sich als wirtschaftliche Alternative zu üblichen Energieübertragungssystemen bisher nicht haben durchsetzen können. Das gilt auch für einen anderen bekannten Leiter (DE-OS 18 12 025), bei dem das supraleitende Element aus einem Niob-Blech dünner Wandstärke besteht, bzw. ein Träger und die supraleitende Schicht ein wellrohrförmiges Bauteil bilden (DE-OS 21 36 019). Wellrohre, konzentrisch angeordnet, wurden aber auch bereits für dünne supraleitende Schichten aus Niob oder Blei verwendet, wobei die Wellrohre mit diesen Materialien ausgekleidet worden sind (AT-PS 278 126).

Zwischenzeitlich sind nun supraleitfähige Verbindungen bekannt geworden, bei denen die Supraleitung um 100 K und etwas darüber erreicht wird. Eine Vielzahl von Veröffentlichungen befassen sich bereits mit diesen Werkstoffen (z. B. EP 0 274 407 A2, EP 321 813 A1 oder auch WO 88/08618), wobei diese Materialien auf Trägerkörper der unterschiedlichsten Art aufgebracht werden. In diesem Zusammenhang ist auch schon vorgeschlagen worden, ("Der Elektriker" 11, 1987, S. 342), die aus den Mischoxiden Yttrium, Barium, Kupfer und Sauerstoff bestehende Keramik in extrem dünner Schicht auf die Oberfläche von Drähten aufzubringen. Eine andere bekannte Maßnahme (WO 89/02656) sieht z. B. ein Hüllmaterial für supraleitende Drähte vor, das aus einer Silberlegierung besteht.

Vorgeschlagen wurde auch bereits die Hestellung von Ba-Y-Cu-O supraleitfähiger Bänder durch einen Oberflächen-Diffusions-Prozess ("Japanese Journal of Applied Physics", July 87, Vol 26, No. 7, pages L1172-L1173).

Eine bekannte Herstellung supraleitfähiger Drähte erfolgt in der Weise, daß supraleitfähiges Keramikpulver in ein metallisches Trägerrohr eingebracht und dieses anschließend auf die gewünschten Endabmessungen heruntergezogen wird ("Japanese Journal of Applied Physics, Vol. 26, No. 10, October 1987, pages 1653-1656).

Ausgehend von diesem Stand der Technik liegt der Erfindung die Aufgabe zugrunde, ein Herstellungsverfahren der eingangs genannten Art für supraleitfähiges Gut anzugeben, mit dem die Produkte in wirtschaftlich vertretbarer Weise herstellbar sind. Dazu gehört ein kontinuierliches Herstellungsverfahren, die erzeugten Produkte sollen trommelbar sein.

Gelöst wird diese Aufgabe gemäß der Erfindung dadurch, daß als Träger ein längseinlaufendes Metallband zu einem Rohr geformt und seine Kanten längsnahtverschweißt werden, daß das verschweißte Rohr gewellt und das gewellte Rohr mit dem oxidkeramischen Werkstoff beschichtet sowie anschließend das beschichtete gewellte Rohr einer Temperaturbehandlung unterworfen wird. Die verwendeten Mischoxide, in der Literatur auch als keramische Werkstoffe bezeichnet, lassen in entsprechender Reinheit eingesetzt und behandelt eine Supraleitung um 100 K und darüber zu. So hohe Sprungtemperaturen gestatten bereits den Einsatz von flüssigem Stickstoff als Kühlmittel und führen gegenüber einer bisher notwendigen Helium-Kühlung zu einer erheblichen Steigerung der Wirtschaftlichkeit. Der Auftrag über Mischoxide auf das Metallrohr sichert die Herstellung von Supraleitern in nahezu unbegrenzter Länge und hoher Biegefähigkeit. Das Metallrohr selbst, beispielsweise aus Kupferwerkstoffen hergestellt, dient als mechanische Stütze auch an Verbindungs- oder Anschlußstellen, aber auch als Normalleiter für den Fall auftretender Schäden, z. B. in der Kühlmittelversorgung.

Das als Träger für die supraleitfähige Schicht dienende gewellte Metallrohr bietet geringste mechanische Beanspruchungen der zugempfindlichen Keramikschicht bei Biegebeanspruchungen. Das Wellrohr kann gleichzeitig als Kühlmittel führendes Transportrohr eingesetzt werden, es bietet dabei einen großflächigen Wärmekontakt für die an der äußeren Oberfläche befindliche Keramikschicht. Bei entsprechender Dimensionierung des Metallrohres ist darüber hinaus z. B. bei einem Kühlmittelausfall eine problemlose Kommutierung auf Normalleitung im gewellten Metallrohr möglich.

In Weiterführung der Erfindung ist vorgesehen, daß das Metallrohr eine wendelförmig verlaufende Wellung aufweist. Diese Wellung hat den Vorteil, daß der Kühlmittelfluß im Inneren des Rohres praktisch rotiert, so daß die auf der Oberfläche des Rohres befindliche Mischoxidschicht gut gekühlt wird.

Vorteilhaft ist es auch, wenn die Beschichtung des gewellten Metallrohres von einem zweiten, ebenfalls gewellten Metallrohr überdeckt wird. Diese Konstruktion läßt eine Erhöhung der Schichtdicke und damit eine Steigerung des elektrischen Leiterquerschnitts zu. Darüber hinaus ergibt sich bei der Herstellung des supraleitfähigen Gutes die Möglichkeit, durch das zweite Metallrohr bei der Temperaturbehandlung des Mischoxides zur Erzeugung der supraleitfähigen Schicht Druck auszuüben und damit den Sintervorgang zu beeinflussen sowie für die Supraleitfähigkeit erforderliche Elemente, wie z. B. Sauerstoff, gasdicht einzuschließen.

Es hat sich ferner als vorteilhaft erwiesen, wenn in Durchführung der Erfindung das Mischoxid, d. h. der keramische Werkstoff, mindestens eines der Elemente Kupfer, Blei oder Wismut enthält. Für die weitere Zusammensetzung der supraleitfähigen Schicht ist mindestens eines der Elemente der Gruppen 2 und 3 des Periodischen Systems wesentlich. Aus der Gruppe 2 sind es vor allem das Strontium (Sr) und das Barium (Ba), die in Kombination mit Elementen der Gruppe 3, wie Yttrium (Y) und Lanthan (La), bereits zu hohen Sprungtemperaturen in der Forschung geführt haben.

Entscheidend für die Erfindung ist der praktische Einsatz der Mischoxide hoher Sprungtemperatur als Supraleiter. Deshalb sieht die Erfindung geeignete Verfahren zur Herstellung solcher Leiter vor, die in praktisch beliebigen Längen herstellbar und trommmelbar sind. Zu diesem Zweck wird ein längslaufendes Metallband zu einem Rohr geformt, an den Kanten längsnahtverschweißt und anschließend gewellt. Das gewellte Rohr wird mit einem supraleitfähigen Pulver aus einem Mischoxid beschichtet, und schließlich wird das beschichtete, gewellte Rohr einer Temperaturbehandlung zum Zwecke der Sinterung unterworfen.

Für die Qualität des Endproduktes, für die elektrische Übertragungsfähigkeit und die Vergleichmäßigung der Kühlung ist es oft besonders zweckmäßig, die supraleitfähigen Mischoxide zwischen zwei Metallschichten anzuordnen. Dabei wird mindestens eine dieser Metallschichten sauerstoffdurchlässig sein. Die Herstellung wird dann vorteilhaft so vor sich gehen, daß zunächst aus einem längseinlaufenden Metallband ein Rohr mit längsnahtverschweißten Bandkanten geformt und anschließend, aber noch im gleichen Arbeitsgang, ein zweites Metallband um das erste Rohr herum zum Rohr geformt wird. Vor dem Verschweißen der Bandkanten des zweiten Rohres wird das supraleitfähige Pulver zwischen die beiden Rohre eingebracht.

Das Einbringen des Pulvers wird so vorgenommen, daß es auf das erste Rohr aufgebracht wird.

Vorteilhaft ist es in Weiterführung der Erfindung ferner, wenn das aus dem zweiten Metallband geformte, längsnahtverschweißte Rohr auf das erste Rohr bzw. die dazwischen befindliche supraleitfähige Schicht zunächst heruntergezogen wird. Anschließend können dann beide Rohre gemeinsam der Temperaturbehandlung unterworfen werden.

Eine Variante im Verfahrensablauf besteht auch darin, daß vor dem Pulverauftrag das gewellte Metallrohr zunächst mit einem Haftvermittler beschichtet wird. Dieser Haftvermittler, z. B. in Form einer Lösung aufgebracht, verdampft bei der anschließenden Temperaturbehandlung, so daß die supraleitende Schicht unmittelbar auf dem Metallrohr haftet. Die Temperaturbehandlung selbst liegt zweckmäßig in Bereichen zwischen 850 und 1650° C, vorzugsweise zwischen 1000 und 1500° C. Diese Werte sind unter anderem auch davon abhängig, aus welchem Metall der Träger für die supraleitfähige Schicht besteht.

Die Erfindung sei anhand der in den Figuren 1 bis 4 dargestellten Ausführungsbeispiele (Figuren 1 und 2) sowie Vergleichsbeispiele (Figuren 3 und 4) näher erläutert.

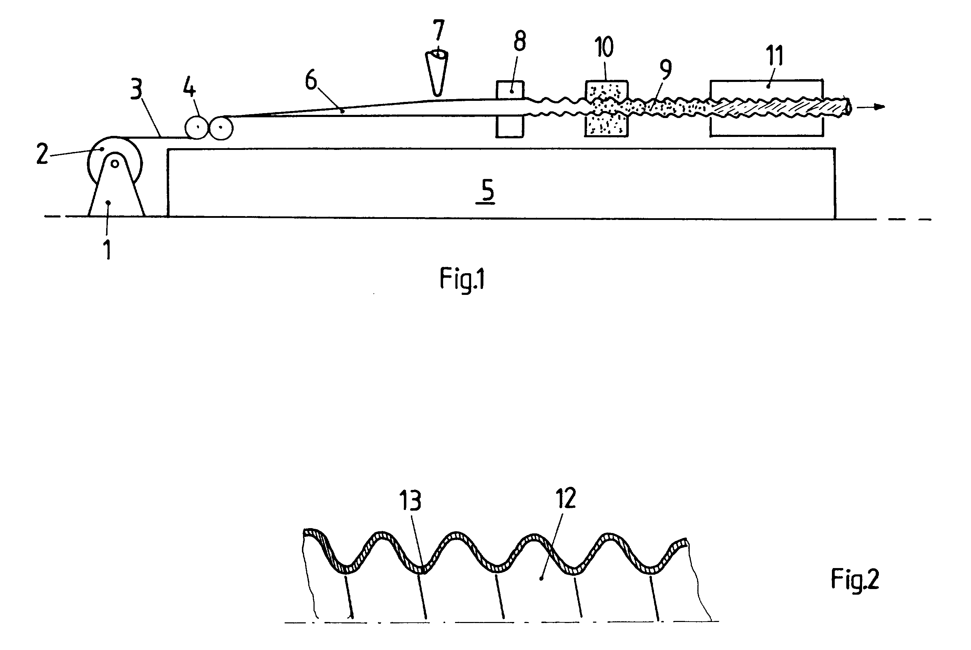

In den Fig. 1, 3 und 4 sind Anlagen zur Herstellung eines Supraleiters, in der Fig. 2 die Variante eines Supraleiters selbst dargestellt.

Von dem auf dem Wickelbock 1 gelagerten Bandvorrat 2 wird das Metallband 3 über eine Umlenkvorrichtung 4, ggf. auch in Form einer Bandreinigung, der Maschinenanlage 5 zugeführt. Im Bereich dieser Anlage wird das Metallband 3 mittels nicht dargestellter und an sich bekannter Formwerkzeuge, wie versetzt angeordnete Rollen oder Walzen, in die Rohrform 6 gebracht. Die Bandkanten des Rohres werden mittels der Schweißvorrichtung 7 fortlaufend verschweißt, und das so hergestellte geschlossene Rohr wird in der Wellvorrichtung 8, beispielsweise mittels umlaufender Wellscheibe, gewellt. Das pulverförmige Mischoxid 9 wird mittels der Vorrichtung 10 gegebenenfalls mit Hilfe eines Wirbelbettes auf das Metallrohr 6 aufgebracht. Das Pulver 9 besteht z. B. aus einem Mischoxid auf Basis Bi - Sr - Ca, Y - Ba - Cu -O. Im anschließenden Wärmeofen 11 erfolgt dann bei den genannten Temperaturwerten die Sinterung des Pulvers und die Erzeugung der supraleitfähigen Schicht.

Einen nach dem Verfahren entsprechend Fig. 1 hergestellten Strang mit supraleitfähigen Eigenschaften zeigt die Fig. 2 . Das gewellte Metallrohr 12 ist an seiner äußeren Oberfläche mit der supraleitfähigen Schicht 13 versehen, die aus einem der genannten Mischoxide aufgebaut ist. Diese Schicht folgt den Wellungen des Rohres, sie ist dauerhaft mit der Rohroberfläche verbunden. Durch die Wellung des Rohres ist die Schicht 13 zugentlastet, das Wellrohr kann wie bisher auch gebogen und zum Zweck des Transportes und der Montage auf Trommeln aufgewickelt werden.

Abweichend von dieser Ausführungsform kann man die supraleitfähige Schicht auch auf ein Metallrohr mit parallel laufender Wellung anordnen. Ebenso ist es möglich, und insbesondere dann vorteilhaft, wenn höhere Leistungen übertragen sind, oberhalb der Schicht 13 ein zweites, entsprechend gewelltes Metallrohr vorzusehen. Auch dieses Rohr wird in einem kontinuierlichen Verfahren dadurch hergestellt, daß ein Metallband zum Rohr geformt sowie anschließend an den Kanten verschweißt und gewellt wird. Nähere Erläuterungen bringen auch hierzu die nachfolgenden Figuren.

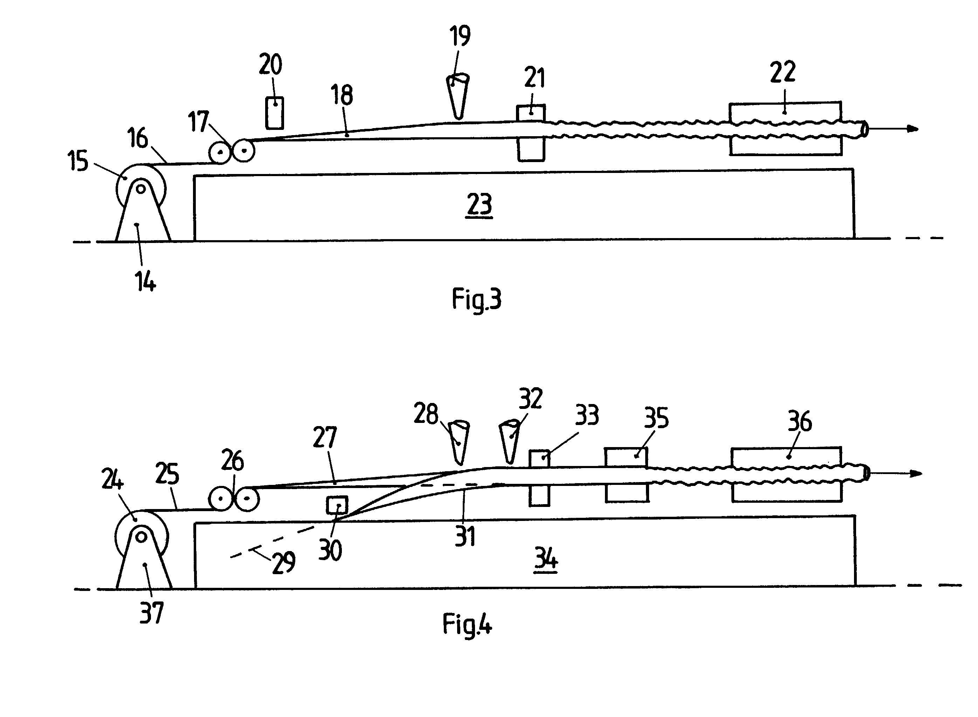

Die Fig. 3 veranschaulicht ein Verfahren, das nicht Gegenstand der Erfindung ist, und bei dem von dem auf den Wickelbock 14 gelagerten Bandvorrat 15 das Metallband 16, ggf. sauerstoffdurchlässig, über eine Umlenkvorrichtung 17 der Maschinenanlage 23 zugeführt wird. Mit Hilfe dieser Anlage wird das Metallband 16 mittels nicht dargestellter Formwerkzeuge in die Rohrform 18 gebracht. Mittels der Schweißvorrichtung 19 werden die Bandkanten fortlaufend verschweißt. Die Vorrichtung 20 dient dazu, das supraleitfähige Pulver auf die ihr zugekehrte Bandfläche vor der Rohrformung aufzubringen, so daß nach dem Verschweißen der Bandkanten die supraleitfähige Schicht sich auf der inneren Rohroberfläche befindet.

Das durch den Schweißvorgang geschlossene Rohr wird in der Vorrichtung 21 gewellt und im Wärmeofen 22 der notwendigen Temperaturbehandlung unterworfen. Vorteilhaft ist hier der unmittelbare Kontakt zwischen Supraleiter und Kühlmittel.

Eine hiervon abweichende Verfahrensvariante zeigt die Fig. 4, die ebenfalls nicht Gegenstand der Erfindung ist. Von einem Wickelbock 37 mit einem Bandvorrat 24 wird ein erstes Band 25 abgezogen sowie über Umlenkrollen 26 der Maschinenanlage 34 zugeführt. In dieser Anlage wird das Band 25, wie bereits anhand der Fig. 1 und 3 beschrieben, zum Rohr 27 geformt. Die Bandkanten dieses Rohres werden durch die Schweißvorrichtung 28 verschweißt. Auf dieses Rohr könnte das supraleitfähige Mischoxid aufgebracht werden. Um jedoch Beschädigungen dieser Schicht beim Wellvorgang zu vermeiden, wird ein zweites Metallband 29 verwendet, auf das mittels der Vorrichtung 30 das supraleitfähige Pulver aufgebracht wird. Wie dargestellt, wird dann dieses, mit dem Pulver beschichtete Metallband 29 um das erste Rohr 27 herum zum Rohr 31 geformt und an den Bandkanten verschweißt. Hierzu dient eine zweite Schweißvorrichtung 32. Noch immer im kontinuierlichen Durchlauf wird dann das Rohr 31 auf das innere Rohr 27 heruntergezogen, und zwar mittels der Zieheinrichtung 33. Anschließend erfolgt die gleichzeitige Wellung der beiden konzentrischen Rohre 27/31 und schließlich die Temperaturbehandlung zum Zwecke der Sinterung der supraleitfähigen Schicht im Wärmeofen 36.

## Patentansprüche

1. Verfahren zur Herstellung eines supraleitenden langgestreckten Gutes aus einem metallischen Träger, der mit einem Mischoxid beschichtet ist, dessen Sprungtemperatur bei 100 K und darüber liegt, dadurch gekennzeichnet, daß als Träger ein längseinlaufendes Metallband zu einem Rohr geformt und seine Kanten längsnahtverschweißt werden, daß das verschweißte Rohr gewellt und das gewellte Rohr mit dem oxidkeramischen Werkstoff beschichtet sowie anschließend das beschichtete gewellte Rohr einer Temperaturbehandlung unterworfen wird.

2. Verfahren nach Anspruch 1, dadurch gekennzeichnet, daß auf das beschichtete erste Wellrohr ein zweites Wellrohr aus einem längseinlaufenden Metallband aufgebracht wird.

3. Verfahren nach Anspruch 2, dadurch gekennzeichnet, daß mindestens eines der für die konzentrischen Rohre verwendeten Metallbänder sauerstoffdurchlässig ist.

## Claims

1. A process for the production of a superconductive elongate material from a metallic carrier coated with a mixed oxide whose transition temperature is 100 K and above, characterised in that by way of carrier a longitudinally inflowing metal strip is shaped into a tube and its edges are longitudinally welded, that the welded tube is corrugated and the corrugated tube is coated with the oxide-ceramic material and then the coated, corrugated tube is subjected to a thermal treatment.

2. A process according to Claim 1, characterised in that a second corrugated tube composed from a longitudinally inflowing metal strip is applied to the coated first corrugated tube.

3. A process according to Claim 2, characterised in that at least one of the metal strips used for the concentric tubes is permeable to oxygen.

## Revendications

1. Procédé pour fabriquer un matériau supraconducteur allongé constitué par un support métallique, qui est recouvert d'un oxyde composite, dont la température de changement brusque de conductivité se situe à 100 K et plus, caractérisé en ce qu'en tant que support, on met en forme une bande métallique arrivant dans la direction longitudinale, sous la forme d'un tube et on soude ses bords au moyen d'un cordon de soudure longitudinal, on met le tube soudé sous une forme ondulée et on recouvre le tube ondulé avec le matériau céramique à base d'oxyde et ensuite on soumet le tube ondulé recouvert à un traitement thermique.

2. Procédé selon la revendication 1, caractérisé en ce qu'on met en place, sur le premier tube ondulé recouvert, un second tube ondulé formé à partir d'une bande métallique arrivant dans la direction longitudinale.

3. Procédé selon la revendication 2, caractérisé en ce qu'au moins l'une des bandes métalliques utilisées pour les tubes concentriques est perméable à l'oxygène.
